# EUROPÄISCHE PATENTSCHRIFT

(11) **EP 0 470 368 B1**
(45) Veröffentlichungstag und Bekanntmachung des Hinweises auf die Patenterteilung: **12.02.1997**
(21) Anmeldenummer: 91110995.7
(22) Anmeldetag: 03.07.1991
(51) Int. Cl.: G01N 27/02, G01R 27/22

(54) **Verfahren und Schaltung zur induktiven Messung der Leitfähigkeit in Flüssigkeiten**
Method and circuit for inductive measuring of conductivity of liquids
Procédé et circuit pour la mesure par induction de la conductivité dans les liquides

(30) Priorität: 08.08.1990 DE 4025093
(43) Veröffentlichungstag der Anmeldung: 12.02.1992
(73) Patentinhaber: Schilling Chemie GmbH u. Produktions KG, D-71691 Freiberg (DE)
(72) Erfinder: Dorsch, Manfred, Prof.Dipl.-Ing., W-6962 Adelsheim (DE); Szulerecki, Gregor Alexander, Dipl.-Ing., W-7100 Heilbronn (DE); Haak, Kurt, W-7129 Ilsfeld-Auenstein (DE)
(74) Vertreter: Clemens, Gerhard, Dr.-Ing.

(56) Entgegenhaltungen:
- DE-A- 1 598 075
- DE-A- 2 822 943
- US-A- 3 389 332
- US-A- 3 491 287
- US-A- 3 510 761

## Beschreibung

Die Erfindung betrifft ein Verfahren zur induktiven Messung der Leitfähigkeit in Flüssigkeiten, mit einem Meßgerät, für das die Meßflüssigkeit einen geschlossenen Stromleiter bildet, der zwei Transformatorkerne miteinander koppelt, von denen der primäre Kern temperaturabhängig mit einer Erregerspannung angeregt und im sekundären Kern eine dadurch induzierte Meßspannung abgegriffen wird, und eine Schaltung zur Ausübung dieses Verfahrens.

Aus der DE-OS 2822943 ist ein Verfahren und eine Schaltung der eingangs genannten Art bekannt, bei der der Salzgehalt als Funktion der gemessenen Leitfähigkeit der Flüssigkeit angezeigt werden soll. Da die Leitfähigkeit vom Salzgehalt und von der Temperatur der Flüssigkeit abhängt, wird auch die Temperatur der Flüssigkeit gemessen und die Erregerspannung in Abhängigkeit von der gemessenen Temperatur so modifiziert, wie es der genannten Abhängigkeit entspricht.

In der DE-A1 1598 075 wird eine bekannte Anordnung zur Ausführung der Verfahren zur Konzentrationsbestimmung von Elektrolyten durch elektrodenlose Leitfähigkeitsmessung beschrieben, bei der die an einer weiteren Wicklung des zweiten Transformators auftretende Spannung direkt als Maß für die Leitfähigkeit der Flüssigkeit verwendet wird. Diese Meßanordnung erfordert jedoch eine stabilisierte Spannungsquelle zur Speisung des ersten Transformators und einen stabilisierten Verstärker zur Anzeige der Ausgangsspannung des zweiten Transformators. Eine weitere unerläßliche Voraussetzung für diese Anordnung ist, daß Eigenschaften des zweiten Transformators, z.B. die Temperaturabhängigkeit der Permeabilität, nicht in die Messung eingehen.

Der vorliegenden Erfindung liegt das Problem zugrunde, die Temperaturabhängigkeit der Permeabilität des Transformators zu kompensieren.

Das erfindungsgemäße Verfahren der eingangs gemäßen Art zeichnet sich demgemäß dadurch aus, daß die Temperaturabhängigkeit der Permeabilität des Kernmaterials kompensiert wird, indem zur Erzeugung der Erregerspannung die Amplitude einer Generatorspannung in Abhängigkeit von der Temperatur mindestens eines der Kerne, vorzugsweise des sekundären Kerns, variiert wird,wobei die tatsächliche Kerntemperatur gemessen wird, die von der Flüssigkeitstemperatur abweichen kann, ein Generator die Generatorspannung erzeugt, wobei dem Generator eine Temperaturkompensationsschaltung nachgeordnet ist, die eingangsseitig zwei parallelgeschaltete Verstärkerzweige aufweist, der erste Verstärkerzweig an einen temperaturabhängigen Widerstand als verstärkungsgradbestimmendes Glied angeschlossen ist, beiden Verstärkungszweigen ein gemeinsamer Summierer nachgeschaltet ist, der die Erregerspannung erzeugt, der temperaturabhängige Widerstand in Berührungskontakt mit dem sekundären Kern angeordnet ist und dem temperaturabhängigen Widerstand ein temperaturunabhängiger Widerstand parallelgeschaltet ist, der der Nichtlinearität der Temperaturabhängigkeit der Kernpermeabilität angemessen ist.

Die Erfindung führt nicht nur zu genaueren Meßwerten der Leitfähigkeit, sondern gestattet es auch, Kernmaterial einzusetzen, das eine hohe Temperaturabhängigkeit und Fertigungsstreuung der Permeabilität hat, und damit billigeres Kernmaterial.

Eine Schaltung, die es auf einfache Weise gestattet, die erste Aufgabe zu lösen, ist dadurch gekennzeichnet, daß ein Generator vorgesehen ist, der die Generatorspannung erzeugt, daß dem Generator eine Temperaturkompensationsschaltung nachgeordnet ist, die eingangsseitig zwei parallel geschaltete Verstärkerzweige aufweist, daß der erste Verstärkerzweig an einen temperaturabhängigen Widerstand als verstärkungsgradbestimmendes Glied angeschlossen ist, daß beiden Verstärkungszweigen ein gemeinsamer Summierer nachgeschaltet ist, der die Erregerspannung erzeugt, daß der temperaturabhängige Widerstand in Berührungskontakt mit dem sekundären Kern angeordnet ist und daß dem temperaturabhängigen Widerstand ein temperaturunabhängiger Widerstand parallelgeschaltet ist, der der Temperaturabhängigkeit der Kernpermeabilität angemessen ist. Wichtig ist, daß die tatsächliche Kerntemperatur gemessen wird, die bei vielen Betriebszuständen erheblich von der Flüssigkeitstemperatur abweicht.

Der Einsatz von zwei Verstärkerzweigen ermöglicht es auf einfache Weise, den temperaturabhängigen und den nicht temperaturabhängigen Anteil der Permeabilität bei der Verstärkung gesondert zu behandeln, was eine Anpassung der Kompensation an eine vorgegebene Kennlinie der Temperaturabhängigkeit der Permeabilität erleichtert.

Es ist aus ökonomischen Gründen wünschenswert, möglichst einfache Kerne einzusetzen, wie zum Beispiel Kerne aus Ferrit. Solche Kerne weisen aber produktionsbedingt erhebliche Streuungen, zum Beispiel auch hinsichtlich der Temperaturabhängigkeit ihrer Permeabilität auf. Es zu ermöglichen, daß solche Kerne dennoch ohne Einbuße hinsichtlich der Meßgenauigkeit und der Kompatibilität einzusetzen sind, ist zweite Aufgabe der Erfindung, deren verfahrensmäßige Lösung dadurch gekennzeichnet ist, daß die produktionsbedingte Streuung der magnetischen Eigenschaften der Kerne durch eine dem jeweils eingesetzten Kern angepaßte Einjustierung der Frequenz der Generatorspannung, insbesondere mittels eines Potentiometers, und entsprechend frequenzabhängige Ausgestaltung der Weiterverarbeitung der Generatorspannung erfolgt.

Die Erfahrung lehrt, daß die produktionsbedingte Streuung sich durch Kennlinien eines Kennlinienfeldes für die Temperaturabhängigkeit der Permeabilität darstellen, die sich in der Hauptsache durch einen von der Temperatur unabhängigen Betrag der Permeabilität unterscheiden und nur in geringem Maße durch einen dem überlagerten von der Temperatur abhängigen Wert. Die durch produktionsbedingte Streuung sich ergebenden Kennlinien sind also im Kennlinienfeld etwa parallel zueinander.

Diese Tatsache nutzt die Erfindung zur schaltungsmäßigen Lösung der zweiten Aufgabe dadurch, daß ein Generator vorgesehen ist, der die Generatorspannung erzeugt, daß ein für die Generatorspannung frequenzbestimmendes Glied des Generators durch eine Handhabe auf unterschiedliche Frequenzen einstellbar ist, daß dem Generator eine Temperaturkompensationsschaltung nachgeordnet ist, die in Abhängigkeit einer, der jeweiligen Frequenz der Generatorspannung zugeordneten Kennlinie arbeitet, welche Kennlinie aus dem durch produktionsbedingte Streuung sich ergebenden Kennlinienfeld der Temperaturabhängigkeit der Kernpermeabilität dem tatsächlich eingesetzten sekundären Kern entspricht.

Es ist dann bei der Produktion nur nötig, bei jeder einzelnen Schaltung das frequenzbestimmende Glied des Generators, zum Beispiel den frequenzbestimmenden Widerstand eines Schwingkreises, entsprechend der vorher gemessenen Permeabilität des in der gleichen Schaltung verwendeten sekundären Kerns einzustellen. Die Schaltung arbeitet dann ganz unabhängig von dem betreffenden Streuwert des eingesetzten sekundären Kerns genauso wie jede andere gleich behandelte Schaltung und alle diese Schaltungen sind dann hinsichtlich ihrer Ausgangssignale kompatibel, wodurch Einsatz, Wartung und Ersatz erheblich vereinfacht werden.

In diesem Zusammenhang erweist sich die oben erwähnte Schaltung mit zwei Verstärkerzweigen als besonders vorteilhaft, weil sich mit dieser Schaltung auf einfache Weise die Weiterverarbeitung der Generatorspannung mit der gewünschten Frequenzabhängigkeit ausgestalten läßt.

Die Nichtlinearität der Magnetisierungskennlinie, insbesondere des sekundären Kerns, führt zu einer entsprechenden nichtlinearen Abhängigkeit der induzierten Meßspannung von der Leitfähigkeit. Dem entgegenzuwirken ist dritte Aufgabe der Erfindung, die verfahrensmäßig dadurch gelöst wird, daß die Nichtlinearität der Magnetisierungskennlinie durch Betrieb des sekundären Kerns in einem festen Arbeitspunkt dieser Kennlinie kompensiert wird, indem die Ausgangsspannung des sekundären Kerns zur Amplitudensteuerung für die Erzeugung der Generatorspannung rückgekoppelt wird, derart, daß die Ausgangsspannung des sekundären Kerns konstant bleibt.

Die dritte Aufgabe läßt sich schaltungsmäßig sehr einfach dadurch lösen, daß ein Generator vorgesehen ist, der die Generatorspannung erzeugt, daß ein durch eine Steuerspannung ansteuerbares, für die Generatorspannung amplitudenbestimmendes Glied des Generators vorgesehen ist und daß dieses Glied mit einer aus der Meßspannung abgeleiteten Steuerspannung angesteuert wird.

Die Amplitude der nach dieser Rückkopplung erzeugten Generatorspannung ist ein unmittelbares Maß für die gemessene Leitfähigkeit. Deshalb empfiehlt es sich, aus der Amplitude dieser Generatorspannung die gewünschte, der gemessenen Leitfähigkeit entsprechende Anzeigespannung abzuleiten.

Das kann man schaltungsmäßig sehr einfach dadurch verwirklichen, daß der Generator parallel zur Temperaturkompensationsschaltung einen Amplitudendetektor ansteuert, dessen Ausgangssignal die gemessene Leitfähigkeit kennzeichnet. Dabei empfiehlt es sich, dem Amplitudendetektor ein Tiefpaßfilter nachzuordnen, das nur Frequenzen passieren läßt, die der zu erwartenden Schwankungsbreite der Leitfähigkeit entsprechen, dagegen die sehr viel höheren oder niedrigeren eventuell vorhandenen Störspannungen zurückhält.

Die Erfindung wird nun anhand der beigefügten Zeichnung näher erläutert.

In der Zeichnung zeigt:
- Figur 1: oberhalb der strichpunktierten Linie eine Schaltung zur induktiven Messung der Leitfähigkeit in Flüssigkeiten, die Teil einer im übrigen unterhalb der strichpunktierten Linie gezeichneten Schaltung zur Ermittlung des Salzgehaltes dieser Flüssigkeit ist,
- Figur 2: die detaillierte Schaltung für den in Figur 1 oberhalb der strichpunktierten Linie gezeichneten Teil, und zwar unter A den linken Teil und unter B den rechten Teil, aneinanderzulegen entlang der strichpunktierten Linien,
- Figur 3: ein Kennlinienfeld der produktionsbedingten Streuung der Temperaturabhängigkeit der Permeabilität der eingesetzten Kerne und
- Figur 4: die Induktivität in Abhängigkeit von der Feldstärke bei dem eingesetzten Kernmaterial.

In der Zeichnung ist mit 1 ein Meßgerät bezeichnet, für das die Meßflüssigkeit, zum Beispiel eine Salzlösung wie Kühlwasser, einen durch den Kreis 2 symbolisierten, geschlossenen Stromleiter bildet, der zwei ringförmige Transformatorkerne 3 und 4 miteinander koppelt. Der primäre Kern 3 weist eine Primärwicklung 5 von beispielsweise fünf Windungen auf, während der sekundäre Kern 4 eine Sekundärwicklung 6 von etwa fünfzig Windungen aufweist. Die beiden Kerne 3 und 4 bestehen aus permeablem Ferrit und sind, bezogen auf ihre Ringachse, koaxial zueinander angeorndet.

Die Primärwicklung und die Sekundärwicklung erstrecken sich nur über einen sehr schmalen Umfangssektor des betreffenden Kerns und sind im rechten Winkel zueinander angeordnet, um auf diese Weise eine gegenseitige störende Kopplung der Wicklungen zu unterbinden.

Mit 7 ist ein Generator bezeichnet, der eine Wechselspannung von 50000 ± 2000 Hz (Hertz = Schwingungen pro Sekunde) erzeugt. Die Frequenz der Generatorspannung ist an dem durch eine Handhabe 8 verstellbaren und einstellbaren Potentiometer P1 als Teil des außerdem aus der Kapazität C1 und dem Widerstand R2 bestehenden frequenzbestimmenden Schwingkreises einstellbar. Die Amplitude der Generatorspannung ist einstellbar durch Einspeisen einer Steuerspannung in den Schaltblock IC1 an dem Eingangsanschluß IC1/1.

Die erzeugte Generatorspannung wird in dem nachgeschalteten Verstärker 9 verstärkt. Der Verstärker 9 steuert zwei eingangsseitig parallel zueinander geschaltete Verstärkerzweige 10, 11 einer Temperaturkompensationsschaltung 12 an. Der Operationsverstärker OP1 des Verstärkerzweiges 11 weist einen parallel geschalteten Widerstand R12 auf und dient zur temperaturunabhängigen Verstärkung des Generatorsignals. Der Verstärkerzweig 10 weist einen Operationsverstärker OP15 auf, dem als verstärkungsgradbestimmendes Glied ein temperaturabhängiger Widerstand RT1 mit einem temperaturunabhängigen Widerstand R10 parallel geschaltet ist. Der Verstärkerzweig 10 verstärkt mithin die Generatorspannung in Abhängigkeit von der Temperatur des Widerstandes RT1 und da dieser Widerstand in unmittelbarem Berührungskontakt an dem sekundären Kern 4 angeordnet ist, ist der Verstärkungsgrad des Verstärkerzweiges 10 abhängig von der Kerntemperatur des sekundären Kerns.

Die Ausgangsspannungen der beiden Verstärkerzweige 10 und 11 werden in dem nachgeordneten Summierer 13 der Temperaturkompensationsschaltung 12 summiert und anschließend in dem nachgeordneten Verstärker 14 zur Erregerspannung verstärkt, mit der die Primärwicklung 5 erregt wird.

Die dadurch in der Sekundärwicklung 6 induzierte Meßspannung ist abhängig von der Leitfähigkeit der Meßflüssigkeit, die den Stromleiter 2 bildet. Diese Meßspannung wird in dem Verstärker 16 verstärkt. Dieser Verstärker 16 besteht aus drei hintereinandergeschalteten Verstärkerstufen 17, 18, 19, von denen die erste als Differenzverstärker ausgebildet ist und die beiden nachfolgenden als invertierende Verstärker ausgebildet sind. Durch den Differenzverstärker werden Fehler durch Einstreuung von Störspannungen vermieden.

Die verstärkte Meßspannung wird in dem aktiven Bandpaßfilter 20 gefiltert und in dem nachgeordneten, an dem Potentiometer P4 einstellbaren Verstärker 21 verstärkt.

Dem Verstärker 21, der dazu dient, die Kondensator-Toleranzen der Filterschaltung auszugleichen, ist ein Amplitudendetektor 22 nachgeschaltet, der ausgangsseitig einen Komparator 23 ansteuert. Diesem Komparator 23 ist ein Differenzspannungszweig mit einem Widerstand R36 und einer Zehnerdiode DR1 zugeordnet. Der Komparator vergleicht das Amplitudensignal aus dem Amplitudendetektor 22 mit der Referenzspannung und steuert mit der daraus abgeleiteten Vergleichsspannung einen Integrator 24 an. Dieser Integrator weist einen Operationsverstärker OP3 auf, dessen Ausgangsspannung zwischen 0 Volt und 8 Volt variiert. Diese Ausgangsspannung gelangt als Steuersignal an den amplitudenbestimmenden Eingang IC1/1 des Schaltblocks IC1 aus dem Generator 7.

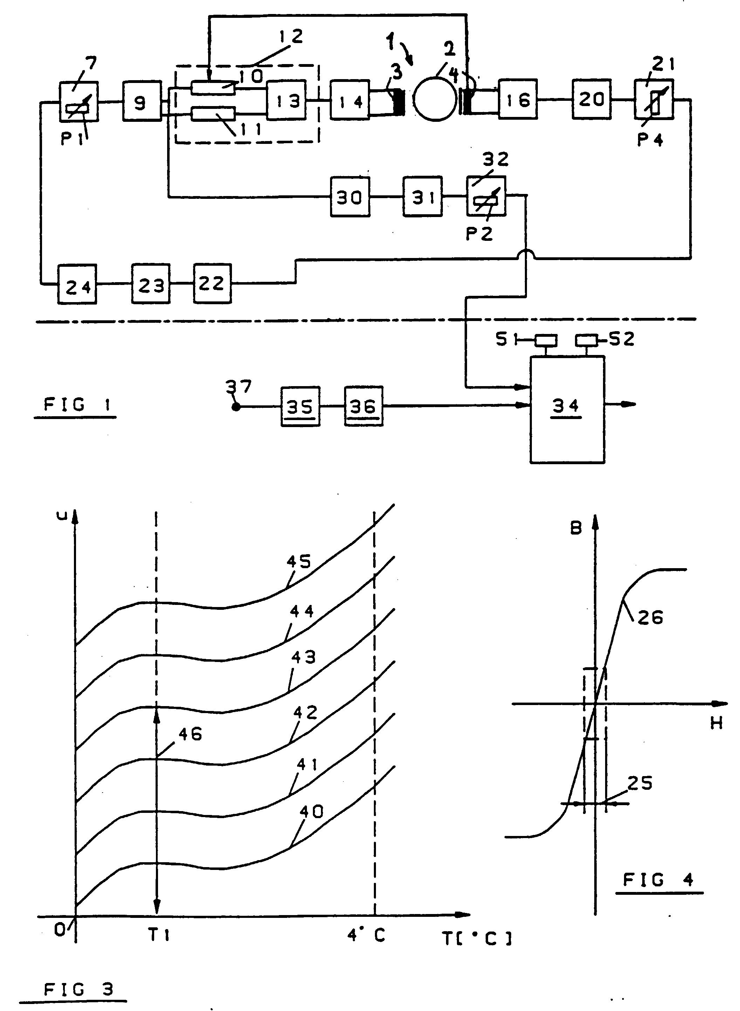

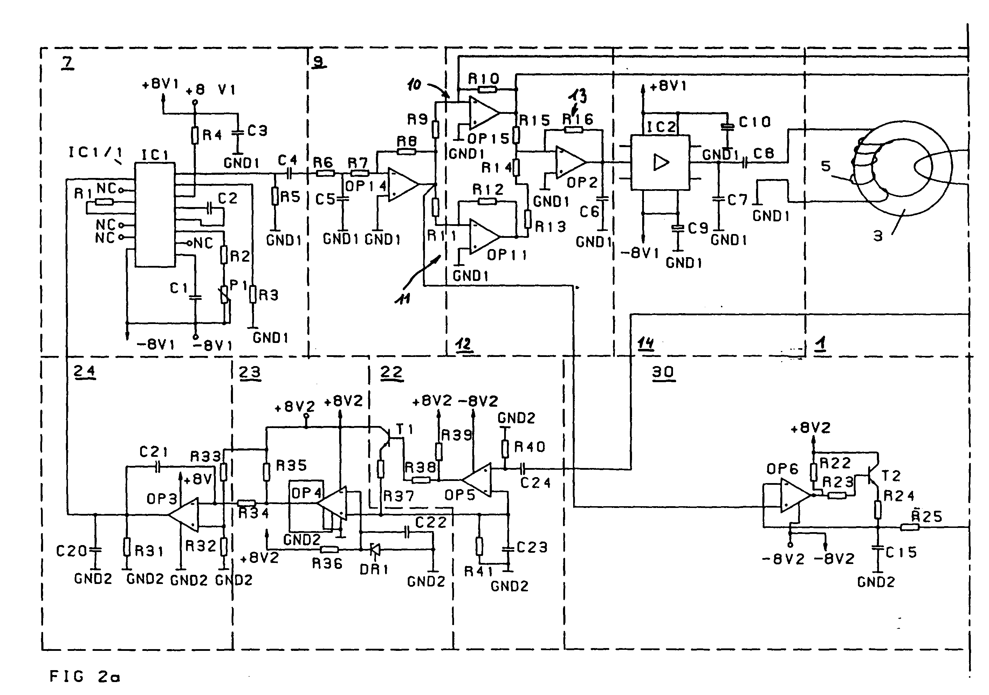

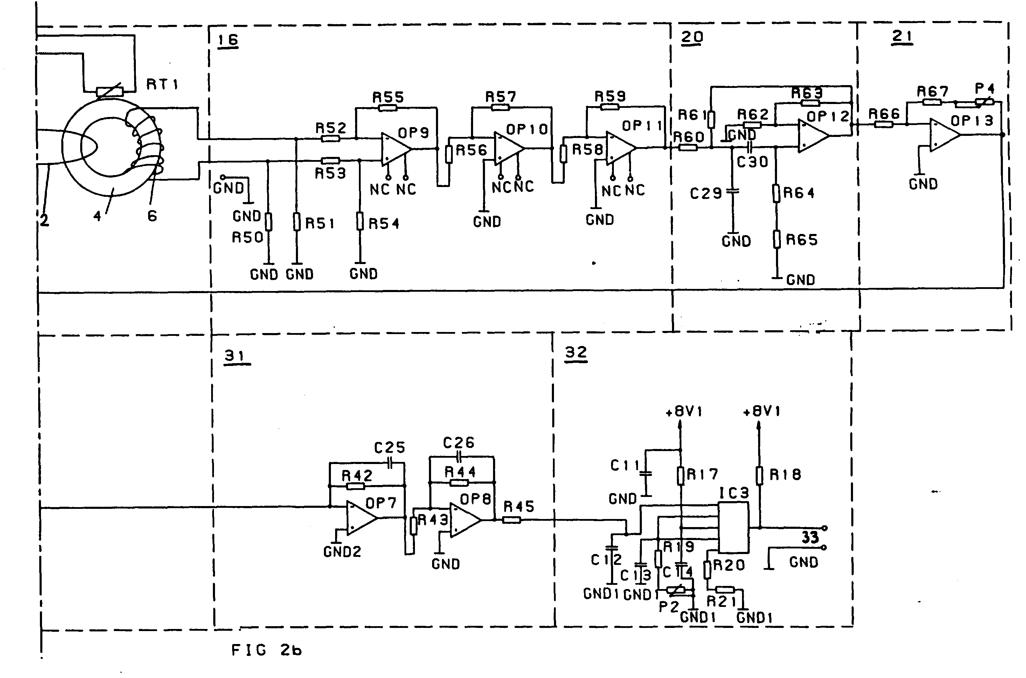

Durch diese Amplitudensteuerung ist die Schaltung rückgekoppelt und diese Rückkopplung ist so ausgelegt, daß die Gesamtverstärkung der Schaltung konstant bleibt. Dadurch wird der Arbeitspunkt des sekundären Kerns immer im Nullbereich gemäß Doppelpfeil 25 der in Figur 4 dargestellten Induktionskennlinie 26 des sekundären Kerns gehalten.

Die Schaltung gestattet es, Kerne einzusetzen, die hinsichtlich ihrer Permeabilität streuen entsprechend den verschiedenen Kennlinien 40 bis 45 aus dem Diagramm gemäß Figur 3. In Figur 3 ist die Permeabilität des sekundären Kerns in Abhängigkeit von der Temperatur aufgetragen. Es stehen aus der Produktion Kerne der Kennlinien 40 bis 45 und mit Zwischenwerten zur Verfügung. Die Schaltung wird auf die betreffende Kennlinie des sekundären Kerns eingerichtet durch Einjustieren des Potentiometers P1 nach den Permeabilitätswerten, die an dem betreffenden Sekundärkern gemessen werden. Die Schaltung arbeitet dann unabhängig von dem zufällig ausgewählten Sekundärkern genauso wie alle anderen Schaltungen dieser Art und ist mit diesen kompatibel.

Bei dieser Kompensation wirkt die Temperaturkompensationsschaltung mit. Im Verstärkerzweig 11 dieser Temperaturkompensationsschaltung wird ein temperaturunabhängiger Anteil der Kennlinie, der beispielsweise durch die Temperatur T1 = 18^{o}C (Grad Celsius) definiert ist, also für die Kennlinie 43 durch den Doppelpfeil 46 angezeigt ist, verstärkt beziehungsweise vermindert auf den entsprechenden temperaturunabhängigen Wert, der für den tatsächlich eingebauten sekundären Kern maßgeblichen Kennlinie. Die diesem temperaturunabhängigen Wert überlagerte temperaturabhängige Komponente der Kennlinie wird in dem Verstärkerzweig 10, der durch den Widerstand RT1 in unmittelbarer Abhängigkeit von der Temperatur des sekundären Kerns arbeitet, entsprechend der zugehörigen Kennlinie dieses sekundären Kerns verändert. Auf diese Weise ist die für die Primärwicklung erzeugte Erregerspannung immer so bemessen, daß sie die jeweilige Permeabilität des sekundären Kerns im Sinne einer Kompensation berücksichtigt, und zwar in allen Auswirkungen, die sich ergeben durch die Produktionsstreuung und durch die Temperaturabhängigkeit.

Bedingt durch die erwähnte Rückkopplung ist das verstärkte Generatorsignal am Eingang der Temperaturkompensationsschaltung 12 in seiner Amplitude ein unmittelbares, lineares Maß für die gemessene Leitfähigkeit. Die Generatorspannung wird deshalb am Ausgang des Verstärkers 9 abgegriffen und einem Spitzenwertgleichrichter 30 zugeleitet. Diesem nachgeordnet ist ein Tiefpaßfilter 31, das die sehr hohe Generatorfrequenz ausfiltert und die niedrige Schwankungsfrequenz der Generatorspannungsamplitude durchläßt. Das Tiefpaßfilter 31 steuert einen Spannungs-Frequenzwandler 32, dessen Umwandlungsverhältnis an dem Potentiometer P2 einstellbar ist. Am Ausgangsanschluß 33 des Spannungs-Frequenzwandlers 32 wird eine Signalspannung abgegriffen, deren Frequenz unmittelbar proportional der Leitfähigkeit ist.

Nach Figur 1 wird diese Signalspannung in ein Auswertgerät 34 eingespeist, das außerdem unter Zwischenschaltung eines Verstärkers 35 und eines Spannungs-Frequenzwandlers 36 von den Meßwerten eines Thermofühlers 37 angesteuert wird. Der Thermofühler 37 taucht in die Flüssigkeit, die den geschlossenen Stromleiter 2 bildet und erzeugt Temperatursignale in Abhängigkeit von der Flüssigkeitstemperatur. Diese Temperatursignale werden mit den von der Löslichkeit abhängigen Ausgangssignalen des Spannungs-Frequenzwandlers 32 in dem Auswertgerät 34 zu einem Ausgangssignal verarbeitet, das den Salzgehalt der Lösung anzeigt und am Ausgang 50 abgegeben wird.

Die dazu nötigen Rechenoperationen des Auswertgerätes 34 sind abhängig von der betrachteten Flüssigkeit und den gelösten Salzen. Die entsprechenden Werte können an den Handhaben 51, 52 in das Auswertgerät 34 eingegeben werden.

Es folgt eine Stückliste der Schaltung zu Figur 2. In dieser Stückliste sind mit R konstante Widerstände, mit P verstellbare Widerstände bzw. Potentiometer, mit C Kondensatoren, mit OP Operationsverstärker und mit IC integrierte Schaltblöcke bezeichnet.

### STÜCKLISTE

- C1 =: 1 uF (uF = Mikrofarad)
- C2 =: 1 nF (nF = Nanofarad)
- C3 =: 100 nF
- C4 =: 1 uF
- C5 =: 10 pF (pF = Pikofarad)
- C6 =: 22 pF
- C7 =: 4.8 nF
- C8 =: 1 uF
- C9 =: 47 uF
- C10 =: 47 uF
- C11 =: 100 nF
- C12 =: 100 pF
- C13 =: 100 nF
- C14 =: 1 nF
- C15 =: 1 uF
- C21 =: 1 uF
- C22 =: 100 nF
- C23 =: 1 uF
- C24 =: 1 uF
- C25 =: 1 uF
- C26 =: 10 nF
- C29 =: 10 pF
- C30 =: 10 pF

- DR1 =: ZN 423 Zehnerdiode

- IC1 =: XA 2206 Sinusgenerator
- IC2 =: LH 0002 Leistungsverstärker
- IC3 =: RC 4151 Spannungs/Frequenz-Wandler

### STÜCKLISTE - Fortsetzung

- OP1 =: LF 347
- OP2 =: LF 347
- OP3 =: CA 3140
- OP4 =: LM 311
- OP5 =: LM 313
- OP6 =: LM 313
- OP7 =: LF 347
- OP8 =: LF 347
- OP9 =: OP-07
- OP10 =: OP-07
- OP11 =: OP-07
- OP12 =: LF 347
- OP13 =: LF 347
- OP14 =: LF 347
- OP15 =: LF 347

- P1 =: 22 k (k = Kilo-Ohm)
- P2 =: 100 k
- P4 =: 100 k

- R1 =: 22 O (O = Ohm)
- R2 =: 22 k
- R3 =: 33 k
- R4 =: 10 k
- R5 =: 10 k
- R6 =: 10 k
- R7 =: 10 k
- R8 =: 10 k
- R10 =: 39 k

### STÜCKLISTE - Fortsetzung

- R11 =: 10 k
- R12 =: 10 k
- R13 =: 3.6 k
- R14 =: 120 O
- R15 =: 10 k
- R16 =: 5,6 k
- R17 =: 6,8 k
- R18 =: 3,9 k
- R19 =: 100 k
- R20 =: 12 k
- R21 =: 2 k
- R22 =: 1k
- R23 =: 56 k
- R24 =: 470 O
- R25: 100 k

- R31 =: 22 k
- R32 =: 8,2 k
- R33 =: 8,2 k
- R34 =: 280 k
- R35 =: 500 O
- R36 =: 750 O
- R37 =: 570 O
- R38 =: 56 k
- R39 =: 1 k
- R40 =: 22 k
- R41 =: 1 M
- R42 =: 100 k
- R43 =: 10 k
- R44 =: 10 k
- R45 =: 100 k

- R50 =: 3,9 k
- R51 =: 3,9 k
- R52: 10 k
- R53 =: 10 k
- R54 =: 56 k
- R55 =: 56 k
- R56: 2.2 k
- R57 =: 10 k
- R58 =: 2.2 k
- R59 =: 10 k
- R60 =: 470 k
- R61 =: 470 O
- R62 =: 10 k
- R63 =: 15 k
- R64 =: 470 O
- R65 =: 470 O
- R66 =: 10 k
- R67 =: 10 k

## Patentansprüche

1. Verfahren zur induktiven Messung der Leitfähigkeit in Flüssigkeiten,
- mit einem Meßgerät (1), für das die Meßflüssigkeit einen geschlossenen Stromleiter bildet, der zwei Transformatorkerne (3,4) miteinander koppelt, von denen der primäre Kern (3) temperaturabhängig mit einer Erregerspannung angeregt und im sekundären Kern (4) eine dadurch induzierte Meßspannung abgegriffen wird,
**dadurch gekennzeichnet**, daß
- die Temperaturabhängigkeit der Permeabilität des Kernmaterials kompensiert wird, indem zur Erzeugung der Erregerspannung die Amplitude einer Generatorspannung in Abhängigkeit von der Temperatur mindestens eines der Kerne (3,4), vorzugsweise des sekundären Kerns (4), variiert wird, wobei die tatsächliche Kerntemperatur gemessen wird, die von der Flüssigkeitstemperatur abweichen kann,
- ein Generator (7) die Generatorspannung erzeugt, wobei dem Generator eine Temperaturkompensationsschaltung (12) nachgeordnet ist, die eingangsseitig zwei parallelgeschaltete Verstärkerzweige (10,11) aufweist, der erste Verstärkerzweig (10) an einen temperaturabhängigen Widerstand (RT1) als verstärkungsgradbestimmendes Glied angeschlossen ist, beiden Verstärkungszweigen ein gemeinsamer Summierer (13) nachgeschaltet ist, der die Erregerspannung erzeugt , der temperaturabhängige Widerstand in Berührungskontakt mit dem sekundären Kern (4) angeordnet ist und dem temperaturabhängigen Widerstand (RT1) ein temperaturunabhängiger Widerstand (R10) parallelgeschaltet ist, der der Temperaturabhängigkeit der Kernpermeabilität angemessen ist.

2. Verfahren nach Anspruch 1,
**dadurch gekennzeichnet,** daß
- die produktionsbedingte Streuung der magnetischen Eigenschaften der Kerne durch eine dem jeweils eingesetzten Kern angepaßte Einjustierung, insbesondere mittels eines Potentiometers (P1), der Frequenz der Generatorspannung und entsprechend frequenzabhängige Ausgestaltung der Weiterverarbeitung der Generatorspannung erfolgt.

3. Verfahren nach einem der vorhergehenden Ansprüche,
**dadurch gekennzeichnet**, daß
- die Nichtlinearität der Magnetisierungskennlinie durch Betrieb des sekundären Kerns (4) in einem festen Arbeitspunkt dieser Kennlinie kompensiert wird, indem die Ausgangsspannung des sekundären Kerns zur Amplitudensteuerung für die Erzeugung der Generatorspannung rückgekoppelt wird, derart, daß die Ausgangsspannung des sekundären Kerns konstant bleibt.

4. Verfahren nach Anspruch 3,
**dadurch gekennzeichnet,** daß
- eine der gemessenen Leitfähigkeit entsprechende Anzeigenspannung aus der Amplitude der Generatorspannung abgeleitet wird.

5. Schaltung zur Ausübung des Verfahrens nach Anspruch 1,
**dadurch gekennzeichnet,** daß
- ein Generator (7) vorgesehen ist, der die Generatorspannung erzeugt,
- dem Generator eine Temperaturkompensationsschaltung (12) nachgeordnet ist, die eingangsseitig zwei parallel geschaltete Verstärkerzweige (10,11) aufweist,
- der erste Verstärkerzweig (10) an einen temperaturabhängigen Widerstand (RT1) als verstärkungsgradbestimmendes Glied angeschlossen ist,
- beiden Verstärkungszweigen ein gemeinsamer Summierer (13) nachgeschaltet ist, der die Erregerspannung erzeugt,
- der temperaturabhängige Widerstand in Berührungskontakt mit dem sekundären Kern (4) angeordnet ist, und
- dem temperaturabhängigen Widerstand (RT1) ein temperaturunabhängiger Widerstand (R10) parallelgeschaltet ist, der der Temperaturabhängigkeit der Kernpermeabilität angemessen ist.

6. Schaltung nach Anspruch 5,
**dadurch gekennzeichnet,** daß
- ein für die Generatorspannung frequenzbestimmendes Glied (P1) des Generators durch eine Handhabe (8) auf unterschiedliche Frequenzen einstellbar ist,
- dem Generator eine Temperaturkompensationsschaltung (12) nachgeordnet ist,die in Abhängigkeit einer, der jeweiligen Frequenz der Generatorspannung zugeordneten Kennlinie (43) arbeitet, welche Kennlinie aus dem durch produktionsbedingte Streuung sich ergebende Kennlinienfeld (40-45) der Temperaturabhängigkeit der Kernpermeabilität dem tatsächlich eingesetzten sekundären Kern entspricht.

7. Schaltung nach Ansprüchen 5 oder 6,
**dadurch gekennzeichnet,** daß
- ein durch eine Steuerspannung ansteuerbares, für die Generatorspannung amplitudenbestimmendes Glied (IC1) des Generators vorgesehen ist und,
- dieses Glied mit einer aus der Meßspannung abgeleiteten Steuerspannung angesteuert wird.

8. Schaltung nach Ansprächen 5,6 oder 7
**dadurch gekennzeichnet,** daß
- der Generator (7) parallel zur Temperaturkompensationsschaltung (12) einen Amplitudendetektor (30) ansteuert, dessen Ausgangssignal die gemessene Leitfähigkeit kennzeichnet.

9. Schaltung nach einem der vorhergehenden Schaltungsansprüche,
**dadurch gekennzeichnet,** daß
- die beiden Verstärkerzweige (10,11) je einen Operationsverstärker (OP1, OP15) mit parallel geschaltetem Widerstand aufweisen, wobei der Widerstand des ersten Verstärkerzweiges (10) der temperaturabhängige Widerstand (RT1) mit einem parallel geschalteten temperaturunabhängigen Widerstand (R10) ist und der Widerstand des zweiten Verstärkerzweiges (11) ein temperaturunabhängiger Widerstand (R12) ist, und
- der nachgeordnete Summierer (13) eingangsseitig einen aus mehreren Widerständen (R13, R14, R15) gebildeten Spannungsabgriff für die Ansteuerung seines Operationsverstärkers (OP2) aufweist.

## Claims

1. Method for the inductive measurement of conductivity in liquids,
- having a measuring instrument (1), for which the liquid to be measured forms a closed current conductor coupling together two transformer cores (3,4) of which the primary core (3) is excited with an excitation voltage as a function of temperature and a measurement voltage induced thereby is tapped in the secondary core (4),
characterized in that,
- the temperature dependence of the permeability of the core material is compensated by varying the amplitude of a generator voltage as a function of the temperature of at least one of the cores (3, 4), preferably the secondary core (4), in order to generate the excitation voltage, with the actual core temperature, which may differ from the liquid temperature, which is measured,
- a generator (7) generates the generator voltage, a temperature-compensation circuit (12) having, on the input side, two amplifier paths (10, 11) connected in parallel, being arranged downstream of the generator, the first amplifier path (10) being connected to a temperature-sensitive resistor (RT1) as the gain determining element, a common adder (13) which generates the excitation voltage being connected downstream of both amplifier paths, the temperature-sensitive resistor being arranged in physical contact with the secondary core (4), and a non-temperature-sensitive resistor (R10) which is appropriate to the temperature-dependence of the core permeability being connected in parallel with the non-temperature-sensitive resistor (RT1).

2. Method according to Claim 1, characterized in that,
- the variation, due to production, in the magnetic properties of the cores takes place by an adjustment, matched to the core respectively used, in particular by means of a potentiometer (P1), of the frequency, the generator voltage and correspondingly frequency-dependent configuration of the post-processing of the generator voltage.

3. Method according to one of the preceding claims, characterized in that,
- the non-linearity in the magnetization characteristic curve is compensated for by operating the secondary core (4) at a fixed working point on this characteristic curve, by feeding back the output voltage of the secondary core to the amplitude control system for the production of the generator voltage, in such a way that the output voltage of the secondary core remains constant.

4. Method according to Claim 3, characterized in that,
- an indication voltage, corresponding to the measured conductivity, is derived from the amplitude of the generator voltage.

5. Circuit for implementing the method according to Claim 1, characterized in that,
- a generator (7) which generates the generator voltage is provided,
- a temperature-compensation circuit (12) having, on the input side, two amplifier paths (10, 11) connected in parallel, is arranged downstream of the generator,
- the first amplifier path (10) is connected to a temperature-sensitive resistor (RT1) as the gain-determining element,
- a common adder (13), which generates the excitation voltage, is connected downstream of both amplifier paths,
- the temperature-sensitive resistor is arranged in physical contact with the secondary core (4), and
- a non-temperature-sensitive resistor (R10) which is appropriate to the temperature-dependence of the core permeability is connected in parallel with the temperature-sensitive resistor (RT1).

6. Circuit according to Claim 5, characterized in that,
- a generator element (P1) which determines the frequency for the generator voltage can be set to different frequencies using a handle (8),
- a temperature-compensation circuit (12) is arranged downstream of the generator and operates according to a characteristic curve (43) assigned to the respective frequency of the generator voltage, which characteristic curve from the characteristic curves (40-45) of the temperature-dependence of the core permeability which result from the variation due to production corresponds to the secondary core actually used.

7. Circuit according to Claims 5 or 6, characterized in that,
- a generator element (IC1) which can be driven by a control voltage and determines the amplitude of the generator voltage is provided, and
- this element is driven using a control voltage derived from the measurement voltage.

8. Circuit according to Claims 5, 6 or 7, characterized in that,
- in parallel with the temperature-compensation circuit (12), the generator (7) drives an amplitude detector (30) whose output signal characterizes the measured conductivity.

9. Circuit according to one of the preceding circuit claims, characterized in that,
- the two amplifier paths (10, 11) each have one operational amplifier (OP1, OP15) with a resistor connected in parallel, the resistor of the first amplifier path (10) being the temperature-sensitive resistor (RT1) with a non-temperature-sensitive resistor (R10) connected in parallel, and the resistor of the second amplifier path (11) being a non-temperature-sensitive resistor (R12), and
- on the input side, the adder (13) arranged downstream has a voltage tap, formed by a plurality of resistors (R13, R14, R15) for driving its operational amplifier (OP2).

## Revendications

1. Procédé pour mesurer par induction la conductivité dans des liquides, comprenant un appareil de mesure (1) pour lequel le liquide à mesurer constitue un conducteur de courant fermé couplant entre eux deux noyaux de transformateur (3, 4), sachant que le noyau primaire (3) est excité par une tension d'excitation en fonction de la température et que, dans le noyau secondaire, on prélève une tension de mesure induite par cela, caractérisé en ce que la dépendance de la température de la perméabilité du matériau qui constitue le noyau est compensée en faisant varier l'amplitude d'une tension de générateur en fonction de la température d'au moins l'un des noyaux (3, 4), de préférence du noyau sccondaire (4), pour produire la tension d'excitation, sachant que l'on mesure la température effective du noyau, laquelle peut différer de la température du liquide, en ce qu'un générateur (7) produit la tension de générateur, sachant qu'un circuit de compensation de la température (12) est monté en aval du générateur, circuit qui présente du côté de l'entrée deux amplificateurs (10, 11) montés en parallèle, que le premier amplificateur (10) est relié à une résistance dépendant de la température (RT1) servant d'élément de détermination du degré d'amplification, qu'en aval des deux amplificateurs est monté un totalisateur commun (13) qui produit la tension d'excitation, que la résistance dépendant de la température est en contact avec le noyau secondaire (4), et qu'une résistance indépendante de la température (R10), qui est adaptée à la dépendance de la température de la perméabilité du noyau, est montée en parallèle avec la résistance dépendant de la température (RT1).

2. Procédé selon la revendication 1, caractérisé en ce que la dispersion des propriétés magnétiques des noyaux qui est conditionnée par la production est due à un ajustement adapté au noyau mis en oeuvre, notamment au moyen d'un potentiomètre (P1), de la fréquence de la tension du générateur, et au traitement ultérieur correspondant de la tension du générateur en fonction de la fréquence.

3. Procédé selon l'une des revendications précédentes, caractérisé en ce que la non-linéarité de la courbe caractéristique de magnétisation, qui est due au fait que le noyau secondaire (4) fonctionne à un point de travail fixe de cette courbe caractéristique, est compensée en couplant rétroactivement la tension de sortie du noyau secondaire afin de commander l'amplitude pour produire la tension du générateur, et ce, de manière à ce que la tension de sortie du noyau secondaire reste constante.

4. Procédé selon la revendication 3, caractérisé en ce qu'une tension indicative correspondant à la conductivité mesurée est dérivée de l'amplitude de la tension du générateur.

5. Circuit pour mettre en oeuvre le procédé selon la revendication 1, caractérisé en ce qu'est prévu un générateur (7) produisant la tension de générateur, en ce qu'un circuit de compensation de la température (12) est placé à la suite du générateur, qui présente du côté de l'entrée deux amplificateurs (10, 11) montés en parallèle, en ce que le premier amplificateur (10) est relié à une résistance dépendant de la température (RT1) en tant qu'organe déterminant le degré d'amplification, en ce qu'en aval des deux amplificateurs est monté un totalisateur commun (13) qui produit la tension d'excitation, en ce que la résistance dépendant de la température est en contact avec le noyau secondaire (4), et en ce qu'une résistance indépendante de la température (R10), qui est adaptée à la dépendance de la température de la perméabilité du noyau, est montée en parallèle avec la résistance dépendant de la température (RT1).

6. Circuit selon la revendication 5, caractérisé en ce qu'un organe (P1) du générateur déterminant la fréquence pour la tension du générateur peut être réglé sur différentes fréquences à l'aide d'une manette (8), en ce qu'un circuit de compensation de la température (12) est monté en aval du générateur, qui travaille en fonction d'une courbe caractéristique (43) associée à la fréquence de la tension du générateur, courbe qui, dans la famille de courbes caractéristiques (40-45) de la dépendance de la température de la perméabilité du noyau résultant de la dispersion liée à la production, correspond au noyau secondaire effectivement mis en oeuvre.

7. Circuit selon la revendication 5 ou 6, caractérisé en ce qu'est prévu un organe (ICl) du générateur qui détermine l'amplitude pour la tension du générateur, et en ce que cet organe est commandé par une tension de commande prise de la tension de mesure.

8. Circuit selon la revendication 5, 6 ou 7, caractérisé en ce que le générateur (7) commande parallèlement au circuit de compensation de la température (12) un détecteur d'amplitude (30) dont le signal de sortie caractérise la conductibilité mesurée.

9. Cireuit selon l'une des revendications précédentes se rapportant au circuit, caractérisé en ce que les deux amplificateurs (10, 11) présentent chacun un amplificateur d'opérations (OP1, OP15) avec une résistance montée en parallèle, la résistance du premier amplificateur (10) étant la résistance dépendant de la température (RT1) avec une résistance indépendante de la température montée en parallèle (R10), et la résistance du second amplificateur (11) une résistance indépendante de la température (R12), et en ce que le totalisateur monté en aval (13) présente du côté de l'entrée une prise de tension constituée de plusieurs résistances (R13, R14, R15) pour commander son amplificateur d'opérations (OP2).
